# EUROPÄISCHE PATENTSCHRIFT

(11) **EP 1 396 182 B1**
(45) Veröffentlichungstag und Bekanntmachung des Hinweises auf die Patenterteilung: **17.11.2004**
(21) Anmeldenummer: 02747212.5
(22) Anmeldetag: 11.06.2002
(51) Int. Cl.: H05K 13/08

(54) **OPTISCHE SENSORVORRICHTUNG**
OPTICAL SENSOR DEVICE
DISPOSITIF CAPTEUR OPTIQUE

(30) Priorität: 12.06.2001 DE 10128476
(43) Veröffentlichungstag der Anmeldung: 10.03.2004
(73) Patentinhaber: SIEMENS AKTIENGESELLSCHAFT, 80333 München (DE)
(72) Erfinder: BESCH, Karl-Heinz, 82140 Olching (DE)
(86) Internationale Anmeldenummer: PCT/DE2002/002128
(87) Internationale Veröffentlichungsnummer: WO 2002/102128

(56) Entgegenhaltungen:
- WO-A-99/20093
- DE-C- 4 003 983
- US-A- 5 298 977
- US-A- 5 469 294
- US-A- 5 758 942

## Beschreibung

Die Erfindung bezieht sich auf eine optische Sensorvorrichtung, mit der Objekte wie beispielsweise Leiterplatten oder Substrate anhand von an den Objekten angebrachten Markierungen erfasst und die räumlichen Positionen der Objekte präzise bestimmt werden können.

Bei der in sogenannten Bestückautomaten durchgeführten automatischen Bestückung von Leiterplatten oder Keramiksubstraten mit Bauelementen, insbesondere SMD - Bauelementen (Surface Mounted Device - Bauelemente), wird vor dem Bestücken die Lage des zu bestückenden Substrats mittels Einrichtungen zur Positionserfassung bestimmt. Unter dem Begriff Bauelemente werden im folgenden alle bestückfähigen Gegenstände erfasst, insbesondere elektronische, elektromechanische oder auch mechanische Bauelemente wie beispielsweise Abschirmbleche. Die Positionserfassung erfolgt im allgemeinen mittels Visionssystemen, welche eine Kamera, beispielsweise eine CCD-Kamera, und eine Beleuchtungseinrichtung umfassen. Neben der Positionserfassung werden Visionssysteme auch zur Qualitätskontrolle verwendet. Dabei werden beispielsweise defekte Substrate, welche sich zusammen mit intakten Substraten auf einem Förderband befinden, erkannt und können somit aus dem automatisierten Bestückprozess entfernt werden.

Zur Positionserfassung der Substrate dienen auf den Substraten aufgebrachte Zentriermarkierungen. Für die Kennzeichnung defekter Substrate werden auf den Substraten aufgebrachte Ausschussmarkierungen benutzt, damit diese defekten Substrate im Rahmen der Qualitätskontrolle identifiziert und anschließend aus dem Bestückprozess entfernt werden können. Für bestückfähige Substrate werden unterschiedliche Materialien wie beispielsweise Keramik, Kunststoff, Hartpapier, kunststoffbeschichtete Pappe und/oder Epoxy-/Glasfaserverbunde verwendet. Als Substrate werden aber auch Kunststoff-Folien eingesetzt, welche ein flexibles Material darstellen und somit ein Verbiegen oder sogar ein Falten ermöglichen. Auch für die Markierungen verwenden die Hersteller von Substraten unterschiedliche Materialien wie beispielsweise glänzende oder matte Metalle bzw. Metalloxide und/oder Kunststoff- oder Lackabdeckungen. Außerdem dienen als Markierungen häufig auch Bohrungen, welche in dem Substrat ausgebildet werden.

Die Hersteller von bestückfähigen Substraten spezifizieren die von ihnen hergestellten Substrate im allgemeinen nur bezüglich der elektrischen und nicht bezüglich der optischen Eigenschaften. Die optischen Eigenschaften der unterschiedlichen für Substrate und Markierungen verwendeten Materialien variieren in der Regel sehr stark. Damit ist auch der durch eine Beleuchtung hervorgerufene Kontrast zwischen den aufgebrachten Markierungen und dem Substrat-Hintergrund großen Schwankungen unterworfen. Die Beleuchtung der Substrate ist daher so zu wählen, dass die auf den Substraten aufgebrachten Markierungen möglichst kontrastreich gegenüber dem Substrathintergrund dargestellt werden.

Für diesen Zweck ist aus der US 5 469 294 ein Beleuchtungssystem bekannt, welches eine oder mehrere Lichtquellen, lichtundurchlässige Trennwände und Spiegel aufweist. Mit dem Beleuchtungssystem werden Markierungen auf einem Substrat, beispielsweise einem Halbleiterwafer, beleuchtet, damit die Markierungen von einer Kamera erfasst werden können, welche parallel oder in einem Winkel zu dem Substrat ausgerichtet ist. Die Lichtquellen umfassen Leuchtdioden (LEDs) und in einem breiten Spektralbereich emittierende Glühlampen. Dunkelfeldbeleuchtungen (die Beleuchtung erfolgt im wesentlichen parallel zur optischen Achse der Kamera) und Hellfeldbeleuchtungen (die Beleuchtung erfolgt im wesentlichen senkrecht zur optischen Achse der Kamera) sind vorgesehen, um ein verbessertes Erkennen von sowohl hellen Markierungen auf dunklem Hintergrund als auch von dunklen Markierungen auf hellem Hintergrund zu erreichen. Eine Lichtsteuereinheit ermöglicht eine manuelle oder eine automatische Steuerung der Lichtintensität.

Aus der WO 99/20093 ist eine Beleuchtungseinrichtung bekannt, welche mehrere Beleuchtungseinheiten aufweist, die jeweils Licht in einem zueinander unterschiedlichen Spektralbereich emittieren. Die Beleuchtungseinheiten können separat in ihrer Intensität variiert werden. Dadurch wird eine Beleuchtung mit variabler Spektralverteilung erzielt, durch die ein ausreichender Kontrast bei der Verwendung von unterschiedlichen Materialien sowohl für die Zentriermarken als auch für die Leiterplatten gewährleistet ist.

Bisher bekannte Beleuchtungseinrichtungen zeichnen sich durch eine spezielle Kombination von Beleuchtungsspektrum und Beleuchtungswinkel aus. Die im Einzelfall verwendete Beleuchtung wird dabei aus einer Vielzahl von möglichen Beleuchtungsspektren und Beleuchtungswinkeln speziell für ein bestimmtes Substrat ausgewählt, wobei die Auswahl im wesentlichen von dem Material des Substrats und einer eventuellen Materialbeschichtung sowie von dem Material und der Art der auf dem Substrat aufgebrachten Markierungen abhängt. Der Bediener ist deshalb gezwungen, bei einem Wechsel von zu bestückenden Substraten die Beleuchtung auszutauschen und/oder manuell umzubauen, so dass die Beleuchtung für die neue Kombination aus den Materialien für das Substrat und den darauf angebrachten Markierungen eine möglichst hohen Kontrast zwischen Substrat-Hintergrund und Markierungen ermöglicht.

Es ist daher Aufgabe der Erfindung, eine optische Sensorvorrichtung zu schaffen, welche für eine Vielzahl von verschiedenen Kombinationen aus Substratmaterial und Material für die auf dem Substrat aufgebrachten Markierungen eine für eine zuverlässige optische Erfassung der Substrate geeignete Beleuchtung sicherstellt, wobei bei einem Wechsel von Substrat- und/oder Marken-Material eine manuelle Anpassung der Sensorvorrichtung nicht erforderlich ist.

Diese Aufgabe wird erfindungsgemäß gelöst durch eine optische Sensorvorrichtung mit einem Lichtdetektor, mit einer Abbildungsoptik, welche ein Messfeld eines zu erfassenden Objekts auf den Lichtdetektor abbildet, wobei der Lichtdetektor auf der optischen Achse der Abbildungsoptik angeordnet ist und mit einem Strahlteiler, welcher auf der optischen Achse zwischen dem Lichtdetektor und dem Messfeld winklig zu der optischen Achse angeordnet ist. Die optische Sensorvorrichtung umfasst ferner eine erste Beleuchtungseinheit, welche das Messfeld in einem schrägen Winkel beleuchtet, eine zweite Beleuchtungseinheit, welche nach einer Reflexion an dem Strahlteiler das Messfeld im wesentlichen parallel zu der optischen Achse beleuchtet, und eine dritte Beleuchtungseinheit, welche das Messfeld im wesentlichen annähernd parallel zu der optischen Achse beleuchtet, wobei zumindest eine der drei Beleuchtungseinheiten zumindest zwei in voneinander unterschiedlichen Spektralbereichen emittierende Leuchtelemente aufweist.

Gemäß zwei bevorzugten Ausführungsformen der Erfindung weisen zumindest zwei der drei Beleuchtungseinheiten, insbesondere die zweite und die dritte Beleuchtungseinheit, zumindest zwei in voneinander unterschiedlichen Spektralbereichen emittierende Leuchtelemente auf. Damit hat die erfindungsgemäße optische Sensorvorrichtung den Vorteil, dass außer den anfänglichen Einstellungen von Beleuchtungsspektrum und Beleuchtungswinkel, welche vor Inbetriebnahme der optischen Sensorvorrichtung durchgeführt werden müssen, kein weiterer mechanischer Umbau oder eine sonstige Justierung der optischen Sensorvorrichtung erforderlich ist.

Gemäß einer weiteren Ausführungsform der Erfindung ist der Lichtdetektor eine CCD-Kamera oder eine CMOS-Kamera. Damit kann auf vorteilhafte Weise ein handelsüblicher CCD- oder CMOS-Chip als Lichtdetektor verwendet werden, so dass die erfindungsgemäße Sensorvorrichtung kostengünstig realisiert werden kann.

Gemäß weiteren Ausführungsformen der Erfindung ist zwischen der ersten Beleuchtungseinheit und dem Messfeld, zwischen der zweiten Beleuchtungseinheit und dem Strahlteiler und/oder zwischen der dritten Beleuchtungseinheit und dem Messfeld ein Diffusor angeordnet. Die erfindungsgemäße Verwendung von Diffusoren hat den Vorteil, dass die Lichtintensität von unerwünschten Reflexionen reduziert und somit der von dem Lichtdetektor erfasste Kontrast erhöht werden kann.

Gemäß einer weiteren bevorzugten Ausführungsform der Erfindung weist die erste Beleuchtungseinheit eine im blauen Spektralbereich emittierende Lichtquelle auf. Die erfindungsgemäße schräge Beleuchtung des Messfeldes mit blauem Licht hat den Vorteil, dass insbesondere metallisch reflektierende Marken, welche sich auf einem hellen Hintergrund, beispielsweise auf einem Keramiksubstrat, befinden, mit hohem Kontrast von dem Lichtdetektor erfasst werden können.

Gemäß zwei weiteren besonders bevorzugten Ausführungsformen der Erfindung weist die zweite Beleuchtungseinheit und/oder die dritte Beleuchtungseinheit eine weißes Licht emittierende Lichtquelle und eine im infraroten Spektralbereich emittierende Lichtquelle auf. Diese Ausführungsformen haben den Vorteil, dass durch eine in einem steilen Winkel auftreffende weiße Beleuchtung insbesondere verzinnte Markierungen zuverlässig erfasst werden können. Da verzinnte Markierungen besonders häufig verwendet werden, stellt die weiße Beleuchtung, welche in einem steilen Winkel bevorzugt als diffuses Licht auf das zu vermessende Substrat auftrifft, die am häufigsten verwendete Standardbeleuchtung der optischen Sensorvorrichtung dar. Die infrarote Beleuchtung, welche in einem steilen Winkel auf das zu vermessende Substrat auftrifft, ist insbesondere dann geeignet, wenn die auf dem entsprechenden Substrat aufgebrachten Markierungen zum Beispiel durch Lötstopplack überdeckt sind. Die Erfassung von überdeckten Markierungen wird zusätzlich verbessert, wenn das steil auf das zu vermessende Substrat auftreffende infrarote Licht außerdem als diffuses Licht auf das Substrat fällt.

Gemäß einem anderen Ausführungsbeispiel der Erfindung ist zumindest eine der Lichtquellen eine Leuchtdiode. Leuchtdioden haben gegenüber anderen Lichtquellen den Vorteil, dass sie zum einen sehr preiswert sind und zum anderen eine hohe Lebensdauer sowie einen geringen elektrischen Energieverbrauch aufweisen.

In einer weiteren Ausführungsform der Erfindung weist die Sensorvorrichtung zusätzlich eine Steuervorrichtung auf, an welche die Lichtquellen angeschlossen sind und mittels welcher die einzelnen Lichtquellen unabhängig voneinander ansteuerbar sind. Dies hat den Vorteil, dass sowohl die Intensität als auch der zeitliche Verlauf der von den einzelnen Lichtquellen emittierten Strahlung individuell festgelegt werden kann und somit für verschiedene Kombinationen von Substratmaterial und Material für die auf dem Substrat aufgebrachten Markierungen eine optimale Beleuchtung erzielt werden kann.

Gemäß einer Weiterbildung der Erfindung weist die Steuervorrichtung einen Parameterspeicher zur Speicherung einer Mehrzahl von Parametern auf, welche für unterschiedliche Arten der Beleuchtung unterschiedliche Ansteuerungen der Lichtquellen festlegen. Damit können für eine Vielzahl von verschiedenen Kombinationen aus Substratmaterial und für die Markierungen verwendetes Material die Parameter für geeignete Beleuchtungen gespeichert und bei einem Wechsel der zu erfassenden Materialienkombination aus Substratmaterial und Markierungsmaterial zuverlässig und schnell die für die neue Materialienkombination geeignete Beleuchtung eingestellt werden.

Zusammenfassend kann festgestellt werden, dass durch die Integration verschiedener Kombinationen von Beleuchtungsspektren und Beleuchtungswinkeln in einer einzigen Sensorvorrichtung und durch eine die einzelne Beleuchtungseinheiten ansteuernde Steuereinheit eine automatische Optimierung der Beleuchtungsparameter für eine Vielzahl von unterschiedlichen Materialien für Substrat und auf dem Substrat angeordneten Markierungen vorgenommen werden kann.

Weitere Vorteile und Merkmale der vorliegenden Erfindung ergeben sich aus der folgenden beispielhaften Beschreibung einer derzeit bevorzugten Ausführungsform.

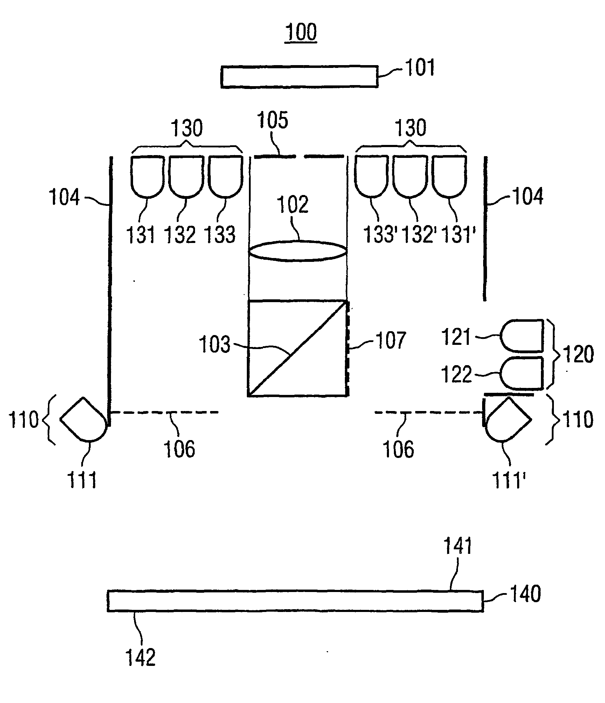

- Figur 1: zeigt eine erfindungsgemäße optische Sensorvorrichtung gemäß einem derzeit bevorzugten Ausführungsbei-. spiel der Erfindung.

In Figur 1 ist eine optische Sensorvorrichtung 100 gemäß einem Ausführungsbeispiel der Erfindung dargestellt. Die Sensorvorrichtung 100 weist einen Lichtdetektor 101, eine Abbildungsoptik 102, einen Strahlteiler 103, eine erste Beleuchtungseinheit 110, eine zweite Beleuchtungseinheit 120 und eine dritte Beleuchtungseinheit 130 auf. Die optische Sensorvorrichtung 100 wird erfindungsgemäß dazu verwendet, eine Oberfläche 141 einer Leiterplatte 140 zu erfassen. Auf der Oberfläche 141 der Leiterplatte 140 befinden sich Markierungen (nicht dargestellt), anhand welcher die Position der Leiterplatte 140 bestimmt wird. Die Leiterplatte 140 liegt im allgemeinen mit ihrer Leiterplatten-Unterseite 142 auf einem Förderband (nicht dargestellt) auf. Die Leiterplatte 140, der Strahlteiler 103, die Abbildungsoptik 102 und der Lichtdetektor 101 sind auf der optischen Achse (nicht dargestellt) der Abbildungsoptik 102 angeordnet. Zwischen Lichtdetektor 101, welcher gemäß dem hier beschriebenen Ausführungsbeispiel der Erfindung ein CCD-Chip oder eine CMOS-Kamera ist, und der Abbildungsoptik 102 ist ferner eine Zentrierblende 105 angeordnet. Die zu vermessende Leiterplatte 140 befindet sich auf der Objektseite der Abbildungsoptik 102. Dementsprechend befindet sich der Lichtdetektor 101 auf der Bildseite der Abbildungsoptik 102. Die Abstände zwischen der Oberfläche 141 der Leiterplatte 140 und der Abbildungsoptik 102 sowie zwischen der Abbildungsoptik 102 und dem Lichtdetektor 101 sind derart gewählt, dass ein Messfeld (nicht dargestellt), mittels welchem ein Teilbereich der Oberfläche 141 der Leiterplatte 140 erfasst wird, durch die Abbildungsoptik 102 auf den Lichtdetektor 101 abgebildet wird.

Die Aufgabe der drei Beleuchtungseinheiten 110, 120 und 130 besteht darin, dass von dem Lichtdetektor 101 mittels der Abbildungsoptik 102 erfasste Messfeld so zu beleuchten, dass die auf der Oberfläche 141 der Leiterplatte 140 befindlichen Strukturen, welche innerhalb des Messfeldes (nicht dargestellt) liegen, mit möglichst hohem Kontrast von dem Lichtdetektor 101 erfasst werden können. Um eine möglichst kontrastreiche Erfassung zu erreichen, erfolgt die Beleuchtung des Messfeldes über verschiedene Beleuchtungswinkel.

Mittels der ersten Beleuchtungseinheit 110, welche zwei Leuchtdioden 111, 111' aufweist, wird das Messfeld relativ zu der optischen Achse der Abbildungsoptik 102 in einem schrägen Winkel beleuchtet. Gemäß dem hier beschriebenen Ausführungsbeispiel der Erfindung emittieren die beiden Leuchtdioden 111, 111' Licht im blauen Spektralbereich. Eine derartige schräge Beleuchtung mittels blauem Licht führt dazu, dass insbesondere metallisch reflektierende Markierungen, welche auf einem hellen Hintergrund, beispielsweise auf einem Keramik-Substrat, von der Sensorvorrichtung 100 zuverlässig erfasst werden können. Mittels der zweiten Beleuchtungseinheit 120, welche eine weißes Licht emittierende Leuchtdiode 121 sowie eine infrarotes Licht emittierende Leuchtdiode 122 aufweist, wird das Messfeld der Sensorvorrichtung 100 annähernd parallel zur optischen Achse der Abbildungsoptik 102 beleuchtet. Diese zur optischen Achse der Abbildungsoptik 102 annähernd parallele Beleuchtung des Messfeldes wird dadurch erreicht, dass das von den beiden Leuchtdioden 121 und 122 emittierte Licht an dem Strahlteiler 103 zumindest teilweise reflektiert wird und somit das Messfeld annähernd parallel zu der optischen Achse der Abbildungsoptik 102 beleuchtet wird. Ein Diffusor 107, welcher zwischen den beiden Leuchtdioden 121 bzw. 122 und dem Strahlteiler 103 angeordnet ist, sorgt dafür, dass das Messfeld, welches über die Abbildungsoptik 102 von dem Lichtdetektor 101 erfasst wird, homogen, d.h. über die Fläche des Messfeldes verteilt mit konstanter Lichtintensität beleuchtet wird. Das auf der Oberfläche 141 der Leiterplatte 140 befindliche Messfeld wird ferner durch die dritte Beleuchtungseinheit 130 im wesentlichen annähernd parallel zur optischen Achse der Abbildungsoptik 102 beleuchtet. Wie aus Figur 1 ersichtlich, weist die dritte Beleuchtungseinheit 130 insgesamt sechs Leuchtdioden 131, 132, 133, 131', 132', 133' auf. Entsprechend der hier beschriebenen derzeit bevorzugten Ausführungsform der Erfindung emittieren die Leuchtdioden 131, 132, 131', 132' weißes Licht und die Leuchtdioden 133, 133' emittieren infrarotes Licht. Um wiederum eine möglichst homogene Beleuchtung des Messfeldes zu erzielen, sind zwischen den Leuchtdioden 131, 132, 133 und dem Messfeld sowie zwischen den Leuchtdioden 131', 132', 133' Diffusoren 106 angeordnet. Ein Gehäuse 104, welches schematisch in Figur 1 dargestellt ist, dient der Befestigung der für die Sensorvorrichtung 100 verwendeten optischen Komponenten, d.h. für die Befestigung des Lichtdetektors 101, der Abbildungsoptik 102, des Strahlteilers 103, der Zentrierblende 105, der Diffusoren 106, 107 sowie für die Befestigung der drei Beleuchtungseinheiten 110, 120 und 130. Die infrarote Beleuchtung des Messfeldes, welche durch die zweite Beleuchtungseinheit 120 und die dritte Beleuchtungseinheit 130 erfolgt, ist insbesondere dann von Bedeutung, wenn mit gutem Kontrastverhalten überdeckte Markierungen, beispielsweise mit Lötstopplack abgedeckte Markierungen, zuverlässig erfasst werden sollen.

Bei abgedeckten Markierungen wird mittels infraroter Beleuchtung gegenüber einer Beleuchtung mit kürzeren Wellenlängen deshalb ein besseres Kontrastverhältnis erzielt, weil im allgemeinen das Material, mit dem die Markierungen abgedeckt sind, für infrarotes Licht eine höhere relative Transmission aufweist als für sichtbares Licht. Als Kompromiss zwischen dem Transmissionsvermögen des Abdeckungsmaterials der Markierungen und der Empfindlichkeit des verwendeten CCD-Sensors wird gemäß dem derzeit bevorzugten Ausführungsbeispiel der Erfindung Licht in einem Spektralbereich um die Zentralwellenlänge von ca. 880 nm verwendet.

Die zweite Beleuchtungseinheit 120 und die dritte Beleuchtungseinheit 330 sind jeweils so realisiert, dass die Leuchtdioden 121, 122, die Leuchtdioden 131, 132, 133 und die Leuchtdioden 131', 132', 133' jeweils auf einer Platine angeordnet sind. Trotz dieser gemeinsamen Anordnung sind sämtliche Leuchtdioden 121, 122, 131, 132, 133, 131', 132', 133' individuell von einer nicht dargestellten Steuervorrichtung ansteuerbar. Dadurch kann durch gezieltes Ausblenden des Hellfeldanteils abhängig von den Materialien der Leiterplatte und der Leiterplatten-Markierungen eine weitere Kontrastverbesserung erreicht werden.

An dieser Stelle sei darauf hingewiesen, dass die Erfindung keineswegs auf die anhand von Figur 1 erläuterte Ausführungsform beschränkt ist. So kann beispielsweise für die drei Beleuchtungseinheiten 110, 120 und 130 im Prinzip jeweils eine beliebige Anzahl von Leuchtdioden verwendet werden, wobei die einzelnen Leuchtdioden in beliebigen Spektralbereichen Licht emittieren können.

## Patentansprüche

1. Optische Sensorvorrichtung (100), insbesondere zur präzisen Positionserfassung von Leiterplatten (140) anhand von auf den Leiterplatten angebrachten Markierungen, mit
• einem Lichtdetektor (101),
• einer Abbildungsoptik (102), welche ein Messfeld eines zu erfassenden Objekts auf den Lichtdetektor abbildet, wobei der Lichtdetektor auf der optischen Achse der Abbildungsoptik angeordnet ist,
• einem Strahlteiler (103), welcher auf der optischen Achse zwischen dem Lichtdetektor und dem Messfeld winklig zu der optischen Achse angeordnet ist,
• einer ersten Beleuchtungseinheit (110), welche das Messfeld in einem schrägen Winkel beleuchtet,
• einer zweiten Beleuchtungseinheit (120), welche nach einer Reflexion an dem Strahlteiler das Messfeld im wesentlichen parallel zu der optischen Achse beleuchtet, und
• einer dritten Beleuchtungseinheit (130), welche das Messfeld im wesentlichen annähernd parallel zu der optischen Achse beleuchtet,
wobei zumindest eine der drei Beleuchtungseinheiten zumindest zwei in voneinander unterschiedlichen Spektralbereichen emittierende Leuchtelemente aufweisen.

2. Sensorvorrichtung gemäß Anspruch 1, wobei zumindest zwei der drei Beleuchtungseinheiten zumindest zwei in voneinander unterschiedlichen Spektralbereichen emittierende Leuchtelemente aufweisen.

3. Sensorvorrichtung gemäß Anspruch 1, wobei die zweite und die dritte Beleuchtungseinheit zumindest zwei in voneinander unterschiedlichen Spektralbereichen emittierende Leuchtelemente aufweist.

4. Sensorvorrichtung gemäß einem der Ansprüche 1 bis 3, bei der der Lichtdetektor eine CCD-Kamera oder eine CMOS-Kamera ist.

5. Sensorvorrichtung gemäß einem der Ansprüche 1 bis 4, bei der zwischen der ersten Beleuchtungseinheit und dem Messfeld ein Diffusor angeordnet ist.

6. Sensorvorrichtung gemäß einem der Ansprüche 1 bis 5, bei der zwischen der zweiten Beleuchtungseinheit und dem Strahlteiler ein Diffusor angeordnet ist.

7. Sensorvorrichtung gemäß einem der Ansprüche 1 bis 6, bei der zwischen der dritten Beleuchtungseinheit und dem Messfeld ein Diffusor angeordnet ist.

8. Sensorvorrichtung gemäß einem der Ansprüche 1 bis 7, bei der die erste Beleuchtungseinheit eine im blauen Spektralbereich emittierende Lichtquelle aufweist.

9. Sensorvorrichtung gemäß einem der Ansprüche 1 bis 8, bei der die zweite Beleuchtungseinheit eine weißes Licht emittierende Lichtquelle und eine im infraroten Spektralbereich emittierende Lichtquelle aufweist.

10. Sensorvorrichtung gemäß einem der Ansprüche 1 bis 9, bei der die dritte Beleuchtungseinheit eine weißes Licht emittierende Lichtquelle und eine im infraroten Spektralbereich emittierende Lichtquelle aufweist.

11. Sensorvorrichtung gemäß einem der Ansprüche 1 bis 10, bei der zumindest eine der Lichtquellen eine Leuchtdiode ist.

12. Sensorvorrichtung gemäß einem der Ansprüche 1 bis 11, zusätzlich aufweisend eine Steuervorrichtung, an welche die Lichtquellen angeschlossen sind und mittels welcher die Lichtquellen unabhängig voneinander ansteuerbar sind.

13. Sensorvorrichtung gemäß Anspruch 12, bei der die Steuervorrichtung einen Parameterspeicher zur Speicherung einer Mehrzahl von Parametern aufweist, welche Parameter für unterschiedliche Arten der Beleuchtung unterschiedliche Ansteuerungen der Lichtquellen festlegen.

## Claims

1. Optical sensor device (100) especially for recording the precise position of circuit boards (140) on the basis of markings applied to the boards, with
• a light detector (101)
• imaging optics (102) which produce an image of an object to be recorded on the light detector, where the light detector is arranged on the optical axis of the imaging optics,
• a beam splitter (103) which is arranged on the optical axis between the light detector and the measurement field at an angle to the optical axis,
• a first illumination unit (110) which illuminates the measurement field at an acute angle,
• a second illumination unit which, after a reflection at the beam splitter, essentially illuminates the measurement field in parallel to the optical axis and,
• a third illumination unit (130) which essentially illuminates
the measurement field almost in parallel to the optical axis, where at least one of the three illumination units features at least two light emitting diodes emitting light in different spectral ranges.

2. Sensor device according to Claim 1, where at least two of the three illumination units feature at least two light emitting diodes emitting light in different spectral ranges from each other.

3. Sensor device according to Claim 1, where the second and the third illumination unit feature at least two light emitting diodes emitting light in different spectral ranges from each other.

4. Sensor device according to one of the Claims 1 to 3, in which the light detector is a CCD camera or a CMOS camera.

5. Sensor device according to one of the Claims 1 to 4, in which a diffuser is arranged between the first illumination unit and the measurement field.

6. Sensor device according to one of the Claims 1 to 5, in which a diffuser is arranged between the second illumination unit and the beam splitter.

7. Sensor device according to one of the Claims 1 to 6, in which a diffuser is arranged between the third illumination unit and the measurement field.

8. Sensor device according to one of the Claims 1 to 7, in which the first illumination unit features a light source emitting light in the blue spectral range.

9. Sensor device according to one of the Claims 1 to 8, in which the second illumination unit features a light source emitting white light and a light source emitting light in the infrared spectral range.

10. Sensor device according to one of the Claims 1 to 9, in which the third illumination unit features a light source emitting white light and a light source emitting light in the infrared spectral range.

11. Sensor device according to one of the Claims 1 to 10, in which at least one of the light sources is a light emitting diode.

12. Sensor device according to one of the Claims 1 to 11, additionally featuring a control device to which light sources are connected and by means of which the light sources can be activated individually.

13. sensor device according to Claim 12, in which the control device features a parameter store for storing a plurality of parameters, with the parameters defining different activation of the illumination for different types of illumination.

## Revendications

1. Dispositif capteur optique (100), notamment pour la détection précise de position de plaquettes à circuit imprimé (140) à l'aide de marquages appliqués sur les plaquettes à circuit imprimé, comprenant
• un détecteur de lumière (101),
• une optique de reproduction (102), laquelle reproduit sur le détecteur de lumière un champ de mesure d'un objet à détecter, le détecteur de lumière étant placé sur l'axe optique de l'optique de reproduction,
• un séparateur de faisceaux (103), lequel est placé sur l'axe optique entre le détecteur de lumière et le champ de mesure, de manière angulaire par rapport à l'axe optique,
• une première unité d'éclairage (110), laquelle éclaire le champ de mesure dans un angle incliné,
• une deuxième unité d'éclairage (120), laquelle, après une réflexion sur le séparateur de faisceaux, éclaire le champ de mesure essentiellement en parallèle à l'axe optique, et
• une troisième unité d'éclairage (130), laquelle éclaire le champ de mesure essentiellement de manière approximative en parallèle à l'axe optique,
au moins une des trois unités d'éclairage présentant au moins deux éléments luminescents émettant dans des domaines spectraux différents les uns des autres.

2. Dispositif capteur selon la revendication 1, au moins deux des trois unités d'éclairage présentant au moins deux éléments luminescents émettant dans des domaines spectraux différents les uns des autres.

3. Dispositif capteur selon la revendication 1, la deuxième et la troisième unités d'éclairage présentant au moins deux éléments luminescents émettant dans des domaines spectraux différents les uns des autres.

4. Dispositif capteur selon l'une quelconque des revendications 1 à 3, dans lequel le détecteur de lumière est une caméra CCD ou une caméra CMOS.

5. Dispositif capteur selon l'une quelconque des revendications 1 à 4, dans lequel un diffuseur est placé entre la première unité d'éclairage et le champ de mesure.

6. Dispositif capteur selon l'une quelconque des revendications 1 à 5, dans lequel un diffuseur est placé entre la deuxième unité d'éclairage et le séparateur de faisceaux.

7. Dispositif capteur selon l'une quelconque des revendications 1 à 6, dans lequel un diffuseur est placé entre la troisième unité d'éclairage et le champ de mesure.

8. Dispositif capteur selon l'une quelconque des revendications 1 à 7, dans lequel la première unité d'éclairage présente une source de lumière émettant dans le domaine spectral bleu.

9. Dispositif capteur selon l'une quelconque des revendications 1 à 8, dans lequel la deuxième unité d'éclairage présente une source de lumière émettant de la lumière blanche et une source de lumière émettant dans le domaine spectral infrarouge.

10. Dispositif capteur selon l'une quelconque des revendications 1 à 9, dans lequel la troisième unité d'éclairage présente une source de lumière émettant de la lumière blanche et une source de lumière émettant dans le domaine spectral infrarouge.

11. Dispositif capteur selon l'une quelconque des revendications 1 à 10, dans lequel au moins une des sources de lumière est une diode luminescente.

12. Dispositif capteur selon l'une quelconque des revendications 1 à 11, présentant en outre un dispositif de commande auquel sont raccordées les sources de lumière et au moyen duquel les sources de lumière peuvent être commandées indépendamment les unes des autres.

13. Dispositif capteur selon la revendication 12, dans lequel le dispositif de commande présente une mémoire de paramètres pour la mémorisation d'une pluralité de paramètres, lesquels paramètres déterminent différentes commandes des sources de lumière pour différents types d'éclairage.
